# EUROPÄISCHE PATENTANMELDUNG

(11) **EP 3 239 350 A1**
(43) Veröffentlichungstag der Anmeldung: **01.11.2017**
(21) Anmeldenummer: 17167058.1
(22) Anmeldetag: 19.04.2017
(51) Int. Cl.: C23C 14/20, B05D 7/02, C08J 9/36

(54) **BESCHICHTETES KUNSTSTOFFBAUTEIL UND VERFAHREN ZUR HERSTELLUNG DES BESCHICHTETEN KUNSTSTOFFBAUTEILS**

(30) Priorität: 27.04.2016 DE 102016207163
(71) Anmelder: Samvardhana Motherson Innovative Autosystems B.V. & Co. KG, 96247 Michelau (DE)
(72) Erfinder: KRAPPMANN, Matthias, 91301 Forchheim (DE)
(74) Vertreter: Isarpatent

(57) **Zusammenfassung**

Die vorliegende Erfindung betrifft ein beschichtetes Kunststoffbauteil (100), insbesondere für einen Innen- und/oder Außenbereich eines Fahrzeugs und ein Herstellungsverfahren, wobei das beschichtete Kunststoffbauteil (100) aufweist: ein geschäumtes Kunststoffbasisbauteil (20), welches auf seiner Außenseite in wenigstens einem Bereich mit wenigstens einer PVD-Schicht (70) versehen ist.

## Beschreibung

### GEBIET DER ERFINDUNG

Die vorliegende Erfindung betrifft ein beschichtetes Kunststoffbauteil, insbesondere ein beschichtetes Kunststoffbauteil für eine Innen- oder Außenverkleidung eines Fahrzeugs, sowie ein Herstellungsverfahren zur Herstellung des beschichteten Kunststoffbauteils.

### TECHNISCHER HINTERGRUND

Im Allgemeinen werden Kunststoffbauteile für Fahrzeuge als Extrusionsteile oder Spritzgussteile hergestellt. Bei herkömmlichen Spritzgussteilen wird flüssiger Kunststoff unter Druck in ein Spritzgusswerkzeug eingespritzt. Dabei kann zusätzlich eine Folie, z.B. eine Metallfolie, in dem Spritzgusswerkzeug vorgesehen werden, welche mit dem flüssigen Kunststoff hinterspritzt wird. Dazu wird die Metallfolie in das Spritzgießwerkzeug eingelegt, mit dem flüssigen Kunststoff hinterspritzt und geprägt, so dass ein Kunststoffteil mit einem entsprechende Metallüberzug entsteht.

Aus der WO 2014/063808 A1 ist des Weiteren ein mit einer eingebetteten PVD-Schicht beschichtetes Kunststoffteil bekannt. Hierbei wird auf ein Kunststoffsubstrat eine 10µm dicke Grundlackschicht aufgebracht. Anschließend wird eine 30nm dicke Chromschicht auf den Grundlack aufgestäubt. Daran anschließend wird eine 100nm dicke Pufferschicht aus Zirkon auf die Chromschicht aufgestäubt. Abschließend wird das Substrat nochmals an Chrom-Targets vorbeigeführt, was zum Aufstäuben einer 60nm dicken Farbschicht aus Chrom führt.
Außerdem sind aus der WO 2013/178363 A2 in Lackschichten eingebettete PVD-Schichten bekannt. Dabei wird auf der Kunststoffoberfläche eines Kunststoffbauteils zunächst eine Basislackschicht aufgebracht. Anschließend wird auf der Basislackschicht eine mittels Abscheiden aus der Gasphase aufgebrachte Schicht bzw. PVD-Schicht vorgesehen, wobei die aus der Gasphase abgeschiedene aufgebrachte Schicht mehrere Lagen aufweist. Auf die aus der Gasphase abgeschiedene Schicht wird wiederum eine Toplackschicht aufgebracht.

Kunststoffteile, welche mit dem zuvor beschriebenen Spritzgussverfahren hergestellt werden, weisen zwar eine gute Oberflächenqualität auf. Ihre Herstellung und Beschichtung ist jedoch aufwendig und mit entsprechenden Kosten verbunden. Außerdem weisen solche Spritzgussteile ein höheres Gewicht auf.

### ZUSAMMENFASSUNG DER ERFINDUNG

Vor diesem Hintergrund liegt der vorliegenden Erfindung die Aufgabe zugrunde, ein verbessertes beschichtetes Kunststoffbauteil bereitzustellen.

Erfindungsgemäß wird diese Aufgabe durch ein beschichtetes Kunststoffbauteil mit den Merkmalen des Patentanspruchs 1 und/oder durch ein Herstellungsverfahren für ein beschichtetes Kunststoffbauteilmit den Merkmalen des Patentanspruches 9 gelöst.

### Demgemäß ist vorgesehen:

Ein beschichtetes Kunststoffbauteil, insbesondere für einen Innen- und/oder Außenbereich eines Fahrzeugs, aufweisend:
ein geschäumtes Kunststoffbasisbauteil, welches auf seiner Außenseite in wenigstens einem Bereich mit wenigstens einer Schicht, insbesondere einer Lackschicht oder einer durch physikalische Gasphasenabscheidung aufgebrachten Schicht oder PVD-Schicht versehen ist.

Das beschichtete Kunststoffbauteil hat den Vorteil, dass es einerseits ein geringeres Gewicht und einen geringeren Teileverzug aufweist, was insbesondere wichtig für den Verbau am Fahrzeug ist, als nicht geschäumte Spritzgussteile. Des Weiteren weist das beschichtete Kunststoffbauteil geringere Herstellungskosten auf, als auch eine sehr gute Oberflächenqualität.

Weiter ist vorgesehen:
Ein Verfahren zur Herstellung eines beschichteten Kunststoffbauteils, insbesondere für einen Innen- und/oder Außenbereich eines Fahrzeugs, wobei das Verfahren die Schritte aufweist:
   Erzeugen eines Kunststoffbasisbauteils durch chemisches Schäumen und/oder physikalisches Schäumen wenigstens eines Kunststoffes; und
   Versehen zumindest eines Bereichs der Außenseite des Kunststoffbasisbauteils mit wenigstens einer Schicht, insbesondere einer Lack-Schicht oder PVD-Schicht.

Das Verfahren hat den Vorteil, dass durch das Schäumen des Kunststoffbasisbauteils die Schließkraft beim Spritzgießen reduziert, sowie die Zykluszeiten verringert werden können. Des Weiteren können Werkzeugkosten aufgrund der geringeren Schließkraft reduziert werden. Durch das Aufbringen wenigstens einer PVD-Schicht kann auf das bisherige aufwendige Folienlaminierungsverfahren verzichtet werden.

Die der vorliegenden Erfindung zugrunde liegende Erkenntnis/Idee besteht darin, ein Kunststoffspritzgussteil mit einem geringen Gewicht kostengünstig herzustellen, wobei beispielsweise auf eine Folierung verzichtet und trotzdem eine Oberflächenbeschichtung vorgesehen werden kann, welche das Kunststoffspritzgussteil mit einer gleichmäßigen Oberfläche ohne Schlieren versieht.

Vorteilhafte Ausgestaltungen und Weiterbildungen ergeben sich aus den weiteren Unteransprüchen sowie aus der Beschreibung unter Bezugnahme auf die Figuren der Zeichnung.

In einer erfindungsgemäßen Ausführungsform ist das Kunststoffbasisbauteil durch chemisches Schäumen und/oder physikalisches Schäumen hergestellt.

In einer weiteren erfindungsgemäßen Ausführungsform ist zwischen der wenigstens einen PVD-Schicht und der Außenseite des Kunststoffbasisbauteils wenigstens eine zusätzliche Schicht vorgesehen. Die wenigstens eine zusätzliche Schicht ist beispielsweise eine Lackschicht, Haftgrundschicht und/oder Pufferschicht.

Gemäß einer erfindungsgemäßen Ausführungsform sind mehrere PVD-Schichten vorgesehen.

In einer erfindungsgemäßen Ausführungsform ist zwischen wenigstens zwei PVD-Schichten wenigstens eine zusätzliche Schicht vorgesehen. Die wenigstens eine zusätzliche Schicht ist beispielsweise eine Lackschicht, Haftgrundschicht und/oder Pufferschicht.

In einer anderen erfindungsgemäßen Ausführungsform ist auf der äußersten PVD-Schicht wenigstens eine zusätzliche Schicht vorgesehen. Die wenigstens eine zusätzliche Schicht ist beispielsweise eine Lackschicht, Deckschicht oder Schutzschicht.

Gemäß einer erfindungsgemäßen Ausführungsform besteht die wenigstens eine PVD-Schicht aus einem Metall, einer Metalllegierung, einem Carbid, einem Oxid und/oder einem Nitrid oder weist dieses zumindest auf. Carbide, Oxide und Nitride erweitern den Einsatzbereich von derartigen beschichteten Kunststoffbauteilen

In einer weiteren erfindungsgemäßen Ausführungsform ist das beschichtete Kunststoffbauteil beispielsweise ein Radlauf, ein Schweller, eine Zierleiste, eine Säulenverkleidung, eine Türverkleidung, ein Spoiler, oder zumindest ein Teil einer Instrumententafel oder diverse andere Fahrzeug-Innen und Aussenbauteile.

In einer erfindungsgemäßen Ausführungsform wird des Weiteren ein Spritzgusswerkzeug mit einer ersten Formhälfte und einer zweiten Formhälfte bereitgestellt, wobei eine oder beide Formhälften jeweils auf ihrer Innenseite zumindest in einem Bereich mit einem elektrisch beheizbaren Heizplattenelement versehen ist bzw. sind, wobei das Heizplattenelement der zugeordneten Formhälfte einen Teil eines Formhohlraums des Spritzgusswerkzeugs bildet, wobei das Heizplattenelement insbesondere ein durch Anlegen eines Stroms und einer Spannung beheizbares Blechteil ist. Der wenigstens eine Kunststoff wird mit einem chemischen Treibmittel und/oder einem physikalischen Treibmittel versehen und in den Formhohlraum zur Erzeugen des Kunststoffbasisbauteils eingespritzt. Durch das Aufheizen des jeweiligen Heizelements können geeignet hohe Temperaturen erzeugt werden, um ein Ausbilden von ungewollten Schlieren an dem Kunststoffbasisbauteil zu verhindern.

Gemäß einer Ausführungsform der Erfindung weist der Schritt des Erzeugens eines Kunststoffbasisbauteils das Aufheizen des Heizplattenelements der einen Formhälfte oder wenigstens eines der beiden Heizplattenelemente der beiden Formhälften auf eine vorbestimmte Temperatur, z.B. Einspritz-Temperatur usw., vor dem Einspritzen, während dem Einspritzen und/oder nach dem Einspritzen des wenigstens einen Kunststoffs in den Formhohlraum auf. Je nach herzustellendem Kunststoffbasisbauteil kann die Temperatur in dem Formhohlraum angepasst werden, wobei der Formhohlraum dabei vor, während und/oder nach dem Einspritzen geheizt werden kann.

In einer erfindungsgemäßen Ausführungsform erfolgt das Aufheizen des Heizplattenelements der einen Formhälfte oder wenigstens eines der beiden Heizplattenelemente der beiden Formhälften auf eine Temperatur, z.B. Einspritz-Temperatur usw., in einem Bereich von z.B. 120°C bis 200°C oder von 130°C bis 170°C beispielsweise zum Einspritzen des wenigstens einen Kunststoffs in den Formhohlraum.

In einer weiteren erfindungsgemäßen Ausführungsform erfolgt ein Temperieren wenigstens einer der Formhälften durch Kühlen und/oder Heizen der Formhälfte vor dem Einspritzen, während dem Einspritzen und/oder nach dem Einspritzen des wenigstens einen Kunststoffs in den Formhohlraum. Auf diese Weise kann das Verfahren gezielt an das herzustellende Kunststoffbasisbauteil angepasst werden, um eine möglichst hohe Oberflächenqualität zu erzielen vor dem anschließenden Beschichten des Bauteils.

In noch einer weiteren erfindungsgemäßen Ausführungsform erfolgt ein kontinuierliches oder diskontinuierliches Aufheizen und/oder Kühlen des Heizplattenelements der einen Formhälfte oder wenigstens einer der beiden Heizplattenelemente der beiden Formhälften, vor dem Einspritzen, während dem Einspritzen und/oder nach dem Einspritzen des wenigstens einen Kunststoffs in den Formhohlraum.

Gemäß einer erfindungsgemäßen Ausführungsform ist die wenigstens eine zusätzliche Schicht, welche beim Beschichten des Kunststoffbasisbauteils aufgebracht wird beispielsweise eine Lackschicht, eine Haftgrundschicht, eine Pufferschicht, eine Funktionsschicht, eine Schutzschicht, z.B. gegen Zerkratzen und/oder UV-Strahlung usw. und/oder eine Deckschicht. Die Funktionsschicht kann beispielsweise wenigsten einen Sensor, z.B. einen Temperatur- und/oder Abstandsensoren, und/oder eine Energieerzeugungseinrichtung aufweisen, beispielsweise zur Nutzung von Sonnenenergie und/oder Wärmeenergie und/oder wenigstens eine Einrichtung zur Informationsübertragung und/oder zum Informationsempfang.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: eine Schnittansicht durch ein beschichtetes Kunststoffbauteil gemäß einer Ausführungsform der Erfindung;
- Fig. 2: eine schematische Ansicht eines Ausführungsbeispiels der Beschichtung des beschichteten Kunststoffbauteils gemäß Fig. 1;
- Fig. 3: ein Flussdiagramm zur Herstellung des beschichteten Kunststoffbauteils gemäß einer Ausführungsform der Erfindung.
- Fig.4: eine Draufsicht auf ein Spritzgusswerkzeug zur Herstellung eines geschäumten Kunststoffbasisbauteils als Basis- oder Rohteil für das erfindungsgemäße beschichtete Kunststoffbauteil;
- Fig. 5: eine Schnittansicht A-A des Spritzgusswerkzeugs gemäß Fig. 4 mit nur einem Heizplattenelement;
- Fig. 6: eine Schnittansicht B-B des Spritzgusswerkzeugs gemäß Fig. 4 mit nur einem Heizplattenelement;
- Fig. 7: eine Schnittansicht A-A des Spritzgusswerkzeugs gemäß Fig. 4 mit zwei Heizplattenelementen;
- Fig. 8: eine Schnittansicht B-B des Spritzgusswerkzeugs gemäß Fig. 4 mit zwei Heizplattenelementen; und
- Fig. 9: eine Schnittansicht des fertigen, mittels des Spritzgusswerkzeugs der Fig. 4 sowie der Fig. 5 und 6 hergestellten geschäumten Kunststoffbasisbauteils.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausgeführt ist -jeweils mit denselben Bezugszeichen versehen.

### BESCHREIBUNG VON AUSFÜHRUNGSBEISPIELEN

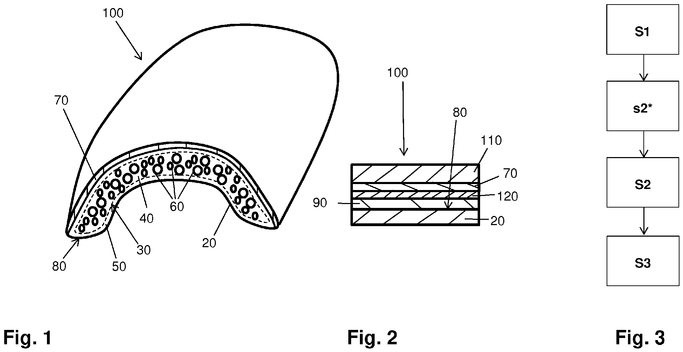

In Fig. 1 ist eine teilweise geschnittene Perspektivansicht eines beschichteten Kunststoffbauteils 100 gemäß einer Ausführungsform der Erfindung gezeigt. Fig. 2 zeigt ein Ausführungsbeispiel der Beschichtung des in Fig. 1 gezeigten beschichteten Kunststoffbauteils 1.

Als beschichtetes Kunststoffbauteil 100 für den Automobilbereich können gemäß der Erfindung beispielsweise Radläufe, Schweller, Zierleisten, Säulenverkleidungen, Türverkleidungen, Spoiler, die Instrumententafel oder Teile davon sowie weitere Kunststoff-Bauteile für den Innenbereich und den Außenbereich bei einem Automobil bzw. Fahrzeug hergestellt werden. Die Erfindung ist jedoch auf die genannten Beispiele nicht beschränkt.

Bei dem erfindungsgemäßen beschichteten Kunststoffbauteil 100 wird zunächst ein Kunststoffbasisbauteil 20 als Basis- oder Rohteil durch chemisches Schäumen und/oder physikalisches Schäumen hergestellt. Das chemische bzw. physikalische Schäumen hat den Vorteil, dass das Gewicht des Kunststoffbasisbauteils 20 erheblich reduziert werden kann. Des Weiteren treten bei dem geschäumten Kunststoffbasisbauteil 20 allenfalls nur geringfügige Bauteilspannungen auf. Bei einer anschließenden Veredelung des Kunststoffbasisbauteils durch Beschichten mit wenigstens einer zusätzlichen Lack- oder PVD-Schicht und einer damit verbundenen Wärmebehandlung, werden daher keine nennenswerten Bauteilspannungen freigesetzt, die ansonsten zu einer Beeinträchtigung der Oberflächenqualität des fertig beschichteten Bauteils führen würden.

Bei herkömmlichen Verfahren, bei welchem das Kunststoffbauteil nicht geschäumt wird, sondern Kunststoff ein - und nachgespritzt wird, tritt dagegen das Problem auf, dass das Kunststoffrohteil erhebliche Bauteilspannungen aufweist. Diese werden beim Nachspritzen von Kunststoff in das Spritzgusswerkzeug verursacht und werden sichtbar, wenn das Kunststoffrohteil anschließend beschichtet und dabei einer Wärmebehandlung unterzogen wird. Die Wärmebehandlung beim Lackieren oder Verchromen des Kunststoffrohteils führt zum Freisetzten dieser Bauteilspannungen. Diese freigesetzten Bauteilspannungen sind am fertig lackierten oder verchromten Kunststoffbauteil sichtbar und beeinträchtigen die Oberflächenqualität des Bauteils. Dies kann durch das erfindungsgemäße geschäumte Kunststoffbauteil 100 verhindert werden.

Beim Schäumen des Kunststoffbasisbauteils 20 wird das Spritzgussmaterial in einem Formhohlraum eines nicht dargestellten Spritzgusswerkzeugs aufgeschäumt und nach dem Aushärten aus dem Spritzgusswerkzeug entfernt. Als Spritzgusswerkzeug wird dabei vorzugsweise ein Spritzgusswerkzeug verwendet, welches eine hohe Werkzeugtemperatur beim Einspritzen aufweist, wobei die Werkzeugtemperatur beim Eispritzen vorzugsweise in einem Bereich von 120°C bis 150°C und insbesondere von 120°C bis 200°C liegt. Die hohe Werkzeugtemperatur beim Einspritzen des Spritzgussmaterials in den Formhohlraum des Spritzgusswerkzeugs hat den Vorteil, dass die Bildung von Schlieren an der Außenseite des herzustellenden geschäumten Kunststoffbasisbauteils 20 verhindert oder zumindest minimiert werden kann. Das Verhindern der Ausbildung derartiger Schlieren an dem geschäumten Kunststoffbasisbauteil 20 hat den Vorteil, dass auf zusätzliche Ausgleichsbeschichtungen zum Ausgleichen dieser ungewollten Schlieren verzichtet werden kann. Dadurch können die Herstellungskosten für das fertig geschäumte Kunststoffbauteil 100 weiter erheblich gesenkt werden. Jede zusätzliche Ausgleichsschicht bedeutet dagegen zusätzliche Bauteilkosten. Ein weiterer Vorteil der oben genannten Werkzeugtemperatur des Spritzgusswerkzeugs ist es, dass die Oberfläche des Spritzgusswerkzeugs und seines Formhohlraums besonders genau abgebildet werden kann. Dadurch können z.B. mikroskopische Unebenheiten in der Oberfläche des Spritzgusswerkzeugs und seiner Formhohlraums zur Erzielung eines sog. Lotus-Effekts bei dem fertigen geschäumten Kunststoffbauteil 100 sehr genau abgebildet werden, bei kleinen wie auch bei großen Kunststoffbauteilen. Bei dem geschäumten Kunststoffbasisbauteil 20 ist kein Nachspritzen von Spritzgussmaterial unter hohem Nachdruck erforderlich. Des Weiteren kann durch das Schäumen des Kunststoffbasisbauteils 20 eine gleichmäßige Fläche über die Länge und Breite des Kunststoffbasisbauteils 20 erreicht werden und zwar auch bei großen Bauteilen.

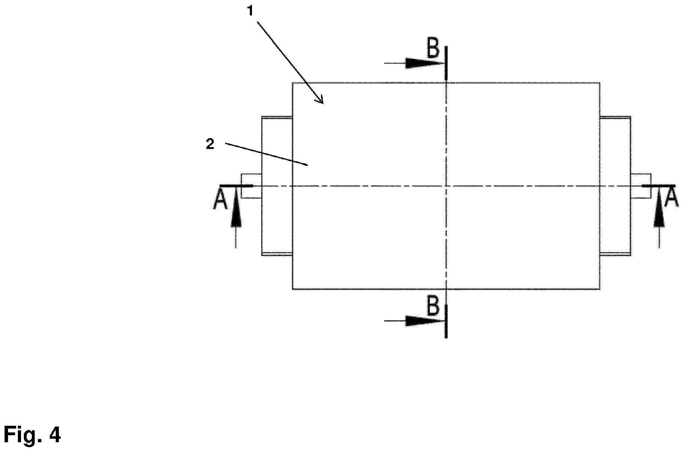

Insbesondere mit dem nachfolgend mit Bezug auf die Fig. 4 bis 9 beschrieben Spritzgusswerkzeug können derart hohe Werkzeugtemperaturen des Spritzgusswerkzeugs beim Einspritzen des Spritzgussmaterials in das Spritzgusswerkzeug in einem Bereich von 120°C bis 150°C sowie bis 200°C und höher erzielt und das Kunststoffbasisbauteil 20 dabei durch chemisches und/oder physikalisches Schäumen mittels des Spritzgusswerkzeugs hergestellt werden. Das nachfolgend mit Bezug auf die Fig. 4 bis 9 beschrieben Spritzgusswerkzeug hat dabei des Weiteren den Vorteil, dass die hohe Werkzeugtemperatur kurzfristig beim Einspritzen des Spritzgussmaterials in das Spritzgusswerkzeug bereitgestellt und anschließend sehr schnell wieder abgesenkt werden kann. Dadurch können die Herstellzeiten für das geschäumte Kunststoffbasisbauteil 20 erheblich gesenkt werden.

Wie zuvor ausgeführt, kann als Spritzgusswerkzeug dabei beispielsweise das in den nachfolgenden Fig. 4-9 gezeigte Spritzgusswerkzeug verwendet werden, wobei die Erfindung jedoch auf dieses spezielle Spritzgusswerkzeug nicht beschränkt ist. Es wird bevorzugt bei der Erfindung ein Spritzgusswerkzeug eingesetzt, dass eine Werkzeugtemperatur beim Eispritzen des Spritzgussmaterials von wenigstens 100°C oder vorzugsweise wenigstens 120°C bereitstellt und wobei die Werkzeugtemperatur nach dem Einspritzvorgang möglichst schnell reduziert werden kann.

Im Anschluss an das Schäumen wird das fertig geschäumte Kunststoffbasisbauteil zumindest in einem Bereich, beispielsweise einem Sichtbereich, mit wenigstens einer Lackoder PVD-Schicht, insbesondere durch physikalische Gasphasenabscheidung aufgebrachten Schicht oder PVD (engl. Physical Vapor Deposition) -Schicht versehen. Im Nachfolgenden wird die Kurzform PVD-Schicht für eine durch physikalische Gasphasenabscheidung aufgebrachte Schicht verwendet.

Das Schäumen des Spritzgussmaterials erfolgt mittels eines chemischen Treibmittels und/oder eines physikalischen Treibmittels.

Bei dem chemischen Treibverfahren, werden die das Spritzgussmaterial aufschäumenden Gase beispielsweise bei der Polymerisation frei. Dies ist zum Beispiel bei Polyurethan (PU)-Schäumen der Fall. Hierbei wird ein chemisches Treibmittel dem Basispolymer bei der Verarbeitung, beispielsweise pulverförmig oder als Granulat, zugemischt. Das chemische Treibmittel zersetzt sich dabei oberhalb einer bestimmten Prozesstemperatur und spaltet ein Treibgas ab, welches sich in der Polymerschmelze löst.

Bei dem physikalischen Treibverfahren wird dem Spritzgussmaterial wiederum ein physikalisches Treibmittel zugesetzt. Als physikalisches Treibmittel kann hierbei beispielsweise ein Treibgas wie CO₂ oder N₂ eingesetzt werden, wobei die Erfindung auf die genannten Beispiele für Treibgase nicht beschränkt ist. Im Gegensatz zu chemischen Treibmitteln findet bei den physikalischen Treibmitteln keine Zersetzungsreaktion statt. Die Polymerschmelze wird direkt mit dem notwendigen Treibgas beladen, wobei eine entsprechende Gasdosierung erfolgt, die größere Gasmengen in dem Polymer lösen kann.

Mittels des Schäumens des Spritzgussmaterials kann beispielsweise ein geschäumtes Kunststoffbasisbauteil 20 mit einer Integralschaumstruktur bzw. Schaumstruktur 30 erhalten werden, wie in Fig. 1 angedeutet ist, mit einem geschäumten Kern 40 und einer kompakten Randschicht 50. Der geschäumte Kern 40 ist in Fig. 1 mit einer gestrichelten Linie dargestellt. Des Weiteren sind die Blasen 60 innerhalb des geschäumten Kerns 40 angedeutet. Die Darstellung in Fig. 1, insbesondere der durch das Aufschäumen entstehenden Blasen 60, ist dabei stark vereinfacht, nicht maßstäblich und rein schematisch zum besseren Verständnis.

Bei dem Spritzgussteil kann sowohl eine möglichst homogene Verteilung über dem Bauteilquerschnitt als auch, je nach Funktion und Einsatzzwecke, eine inhomogene oder zumindest teilweise inhomogene Verteilung der Schaumstruktur im Bauteilquerschnitt erzeugt werden, durch eine geeignete Einstellung von Prozessparametern, wie der Temperatur oder dem Temperaturverlauf des Spritzgussmaterials im Formhohlraum des Spritzgusswerkzeugs, dem verwendeten Treibmaterial, dem Einspritzdruck, der Einspritzgeschwindigkeit usw..

Generell gilt, dass durch physikalisches Schäumen in der Regel eine gleichmäßigere Schaumstruktur erzielt werden kann, wobei die Blasen hier häufiger und kleiner sind. Beim chemischen Schäumen kann wiederum eine Schaumstruktur erzielt werden, die etwas ungleichmäßiger ist und weniger und größere Blasen aufweist, als wie bei dem physikalischen Schäumen.

Die Darstellung des fertigen beschichteten Kunststoffbauteils 100 als längliches, Element mit einem C-förmigen Querschnitt in Fig. 1 ist lediglich beispielhaft und dient nur zu Veranschaulichung des Prinzips der Erfindung.

Grundsätzlich kann das fertige beschichtete Kunststoffbauteil 100 eine beliebig komplexe Form aufweisen mit z.B. Vertiefungen, Erhebungen oder Vorsprüngen, Wölbungen usw..

Neben kleinen können auch großflächige geschäumte Kunststoffbasisbauteile 20, insbesondere für den Fahrzeuginnenbereich und Fahrzeugaußenbereich, mit einem deutlich geringeren Gewicht hergestellt werden, und anschließend mit wenigstens einer Schicht, insbesondere einer Lack-Schicht oder PVD-Schicht versehen werden. Hierbei kann beispielsweise je nach Produktdesign bei dem beschichteten Kunststoffbauteil eine Gewichtsersparnis in einem Bereich von z.B. 10% bis 50% erzielt werden. Die hohen erreichbaren Werte an Gewichtsersparnis gründen auf der Möglichkeit, sogenannte "2-schalige Konzepte" in "1-schalige Konzepte" umwandeln zu können.
Hier ist mit "2-schalig" ein Konzept aus zwei Bauteilen gemeint. Eine Unterschale mit entsprechenden Befestigungselementen, z.B. Verclipsungs- und/oder Verrastungselementen, zum Befestigen am Fahrzeug bildet das sog. Funktions-Teil und eine Oberschale bildet das sichtbare Teil oder sog. Design-Teil mit der Aufgabe, eine hochwertige Oberfläche mit entsprechender Passgenauigkeit bezüglich Spaltmaßen und Gesamtverzug abzubilden.

Ein "1-schaliges Konzept" vereint beide gerade beschriebenen Aufgaben in einem Bauteil. Mit anderen Worten, bei dem 1-schaligen Konzept gibt es statt einer Unterschale und einer Oberschale nur eine Schale, welcher an der Unterseite als Funktionsteil beispielsweise ein oder mehrere Befestigungselemente, z.B. wenigstens ein Verclipsungs- und/oder Verrastungselement, zum Befestigen am Fahrzeug aufweist und wobei die Oberseite der Schale das sichtbare Teil oder sog. Design-Teil bildet und eine hochwertige Oberfläche mit einer entsprechenden Passgenauigkeit bezüglich Spaltmaßen und Gesamtverzug bereitstellt.

Das Ergebnis des "1-schaligen Konzepts" ist eine enorme Gewichtsersparnisse von bis zu 50 % und mehr. Des Weiteren kann eine Bauraumersparnis am und im Fahrzeug erzielt sowie zusätzliche Designmöglichkeiten bereitgestellt werden. Die Herstellungskosten des "1-schaligen Konzeptes" sind darüber hinaus entsprechend günstiger als die des "2-schaligen Konzeptes".
Für das zu schäumende Kunststoffbasisbauteil oder Kunststoffspritzgussbauteil 20 als Basis- oder Rohteil kann als Spritzgussmaterial ein Kunststoff wie z.B. ein Duroplast, ein Polymer oder Polymerwerkstoff, insbesondere ein Thermoplast, ein Elastomer und/oder ein thermoplastisches Elastomer eingesetzt und in den Formhohlraum des Spritzgusswerkzeugs eingespritzt werden. Es können z.B. Kunststoffe, insbesondere Polymerwerkstoffe wie Polyurethan (PU), Polycarbonat (PC), Polystyrol (PS) und dessen Copolymere wie z.B. Acrylnitril-Butadien-Styrol (ABS), alle Polyamide (PA), Polyoxymethylen (POM), Polymethylmethacrylat (PMMA)oder Polyolefine, wie z.B. Polypropylen (PP), oder thermoplastische Elastomere (TPE) wie z.B. thermoplastische Polyolefine (TPO) oder Ethylen-Propylen-Dien-Kautschuk (EPDM) usw. verwendet werden. Dabei können die Kunststoffe, wie z.B. thermoplastische Kunststoffe, wahlweise zusätzlich durch Füllstoffe und/oder Additive für die Spritzgußverarbeitung und die spätere Verwendung modifiziert werden. Als Füllstoff können z.B. Granulate, Fasern wie z.B. Glasfasern, Kohlenstofffasern, Aramidfasern, Basaltfasern, Keramikfasern, Naturfasern, Nylonfasern, Mineralverstärkungen oder Talkumverstärkungen usw. vorgesehen werden, je nach Funktion und Einsatzzweck. Die Erfindung ist jedoch auf die zuvor genannten Kunststoffe und Füllstoffe nicht beschränkt. Es kann jede Art von Kunststoff und Füllstoff sowie Additiv eingesetzt werden, welche zur Herstellung eines beschichteten Kunststoffbauteils mit einem hierbei chemisch und/oder physikalisch geschäumten Kunststoff-Basisbauteil geeignet sind.

Nach der Fertigstellung des geschäumten Kunststoffbasisbauteils 20 als Basis- oder Rohteil wird dieses an seiner Außenseite, z.B. auf seiner Sichtseite, mit wenigstens einer Lack-Schicht oder PVD-Schicht 70 versehen.

Dabei kann beispielsweise wenigstens eine PVD-Schicht 70 aus Metall oder einer Metalllegierung auf die Außenseite 80 des geschäumten Kunststoffbasisbauteils 20 durch physikalische Gasphasenabscheidung aufgebracht werden, beispielsweise mittels eines Kathodenzerstäuberverfahrens wie z.B. Sputter mittels eines Magnetrons im Vakuum usw.. Die PVD-Schicht 70 ist dabei in der Schnittansicht in Fig. 1 gezeigt. In Fig. 2 ist dabei ein Ausführungsbeispiel des beschichteten Kunststoffbauteils 100 gemäß Fig. 1 gezeigt, wobei das erfindungsgemäße beschichtete Kunststoffbauteil 100 neben der einen zuvor in Fig. 1 gezeigten PVD-Schicht 70 zusätzliche weitere Schichten aufweist.

Die Erfindung ist weder auf eine physikalische Gasphasenabscheidung mittels einem Kathodenzerstäuberverfahren noch auf Sputtern mittels eines Magnetrons im Vakuum zum Bereitstellen der wenigstens einen PVD-Schicht 70 beschränkt. Es kann jedes Verfahren zur physikalischen Gasphasenabscheidung eingesetzt werden, welches geeignet ist ein physikalisch und/oder chemisch geschäumtes Kunststoffbasisbauteil 20 mit wenigstens einer zusätzlichen PVD-Schicht 70 in einem Bereich seiner Außenseite 80 zu versehen.

Führt man bei dem Beschichtungsprozess Reaktivgase wie Sauerstoff, Stickstoff oder Kohlenwasserstoffe zu lassen sich auch Oxide, Nitride oder Carbide abscheiden und als PVD-Schicht 70 vorsehen.

Das geschäumte Kunststoffbasisbauteil 20 als Basis- oder Rohteil kann vor dem Aufbringen wenigstens einer PVD-Schicht 70 mit wenigstens einer Zwischenschicht 90 versehen sein, wie in Fig. 2 gezeigt ist. Die wenigstens eine Zwischenschicht 90 ist dabei zwischen dem geschäumten Kunststoffbauteil 20 bzw. der Außenseite 80 des geschäumten Kunststoffbauteils 20 und der PVD-Schicht 70 vorgesehen. Als wenigstens eine Zwischenschicht 90 kann dabei z.B. eine Haftgrundschicht vorgesehen werden, welche die Haftung oder Verbindung mit der nachfolgenden PVD-Schicht 70 verbessert oder erhöht.

Zusätzlich oder alternativ zu der Haftgrundschicht kann auch wenigstens eine andere Schicht, z.B. Lackschicht 120, zwischen der Zwischenschicht 90 und dem geschäumten Kunststoffbasisbauteil 2 und/oder zwischen der Zwischenschicht 90 und der PVD-Schicht 70 vorgesehen sein, wie in Fig. 2 gezeigt, je nach Funktion und Einsatzzweck.

Des Weiteren kann auch zwischen wenigstens zwei nicht dargestellten PVD-Schichten wenigstens eine zusätzliche Schicht, z.B. Lackschicht, Haftgrundschicht, Pufferschicht, nachfolgend beschriebene Funktionsschicht, Schutzschicht usw., vorgesehen werden, je nach Funktion und Einsatzzweck.

Außerdem kann auch auf der obersten oder äußersten PVD-Schicht 70, wie in Fig. 2 gezeigt ist, wenigstens eine weitere Schicht 110, z.B. wenigstens eine Deckschicht oder zusätzliche Schutzschicht gegen Steinschlag, UV-Strahlung und/oder Korrosion usw., vorgesehen werden. Beispielsweise kann als eine weitere Schicht 110 eine Funktionsschicht oder "intelligente" Funktionsschicht, vorgesehen werden und zusätzliche Aufgaben übernehmen. In dieser Funktionsschicht oder intelligenten Funktionsschicht können z.B. ein oder mehrere Sensoren, wie beispielsweise Temperatur- und/oder Abstandsensoren usw., integriert sein und/oder "Energieerzeugungs-Techniken" wie z.B. Techniken zur Nutzung von Sonnenenergie und/oder Wärmeenergie, beispielsweise aufgrund von hohen Temperaturen im Fahrzeug-Innenraum usw., und/oder wenigstens eine Einrichtung zur Informationsübertragung und/oder zum Informationsempfang integriert sein. Diese "intelligente" Funktionsschicht muss dabei nicht als oberste Schicht 110 vorgesehen werden, sondern, kann ebenfalls als Zwischenschicht 90 vorgesehen werden, je nach Funktion und Einsatzzweck.

Bei herkömmlichen Veredelungsprozessen, wie beispielsweise dem Lackieren, ist bei der Herstellung des Rohteils die Anwendung des chemischen oder physikalischen Schäumens nicht möglich, da die Rohteiloberfläche mit sog. Schlieren überzogen ist. Diese Schlieren können durch die Lackierung nicht vollständig egalisiert werden. Nur durch einen mehr-schichtigen Lackaufbau kann eine entsprechend notwendige Oberflächenqualität erzeugt werden. Dieser Aufwand steht aber in keinem wirtschaftlichen Verhältnis zum erzielten Nutzen.

Durch das beschriebene Verfahren kann ein beschichtetes Kunststoffbauteil 100 hergestellt werden, dass aufgrund der geschäumten Struktur eine erhebliche Gewichtsreduzierung sowie eine Reduzierung der Schließkraft des Spritzgusswerkzeugs erlaubt. Des Weiteren kann die Zykluszeit des Spritzgussprozesses reduziert werden, sowie Kosten des Spritzgussverfahrens gesenkt werden. Zudem kann die Technologie des Aufbringens einer PDV-Beschichtung auf ein breites Teilespektrum erweitert werden.

In Fig. 3 ist ein Flussdiagramm zur Herstellung des beschichteten Kunststoffbauteils gemäß einer Ausführungsform der Erfindung gezeigt.

In einem ersten Schritt S1 wird zunächst ein geschäumtes Kunststoffbasisbauteil durch chemisches Schäumen und/oder physikalisches Schäumen im Spritzgussverfahren hergestellt. Dabei kann ein Spritzgusswerkzeug eingesetzt werden, wie es in den nachfolgenden Fig. 4 bis 8 gezeigt ist. Die Erfindung ist jedoch auf dieses spezielle Spritzgusswerkzeug nicht beschränkt. Es kann jedes andere Spritzgusswerkzeug eingesetzt werden, das geeignet ist ein geschäumtes Kunststoffbasisbauteils als Basis- oder Rohteil herzustellen.

In einem nächsten Schritt S2 wird wenigstens ein Bereich der Außenseite des geschäumten Spritzgussteils oder Kunststoffbasisbauteils mit wenigstens einer PVD-Beschichtung oder PVD-Schicht, z.B. aus wenigstens einem Metall oder wenigstens einen Metalllegierung, versehen, beispielsweise durch Sputtern mittels eines Magnetrons im Vakuum.

Zwischen jeweils zwei PVD-Schichten kann in dem Schritt S2 des Weiteren wenigstens eine zusätzliche Schicht vorgesehen werden, z.B. Lackschicht, Haftgrundschicht, Pufferschicht, , je nach Funktion und Einsatzzweck.

Dabei kann in einem Schritt s2* zwischen dem Schritt S1 und dem Schritt S2, vor der PVD-Beschichtung wenigstens eine zusätzliche Schicht, z.B. eine Lackschicht und/oder Haftgrundschicht, zwischen dem wenigstens einen Bereich der Außenseite des geschäumten Kunststoffbasisbauteils bzw. Spritzgussteils und der untersten PVD-Schicht, im Falle von mehreren PVD-Schichten, vorgesehen werden. Die Lackschicht kann durch ein geeignetes Lackierverfahren aufgetragen werden. Gleiches gilt für das Aufbringen der Haftgrundschicht.

Auf die äußerste PVD-Schicht bzw. die Außenseite oder Oberfläche der äußersten PVD-Schicht kann anschließend in einem Schritt S3 wenigstens eine zusätzliche Schicht, beispielsweise eine Deckschicht, Funktionsschicht, insbesondere "intelligente Funktionsschicht", und/oder Schutzschicht aufgebracht werden, wie zuvor beschrieben.

Fig. 4 zeigt eine Draufsicht auf ein Spritzgusswerkzeug 1 zur Herstellung des zuvor mit Bezug auf die Fig. 1-3 beschriebenen geschäumten Kunststoffbasisbauteils als Basisoder Rohteil. Das Spritzgussbauteil 1 kann dabei mit einem oder zwei Heizplattenelementen versehen werden.

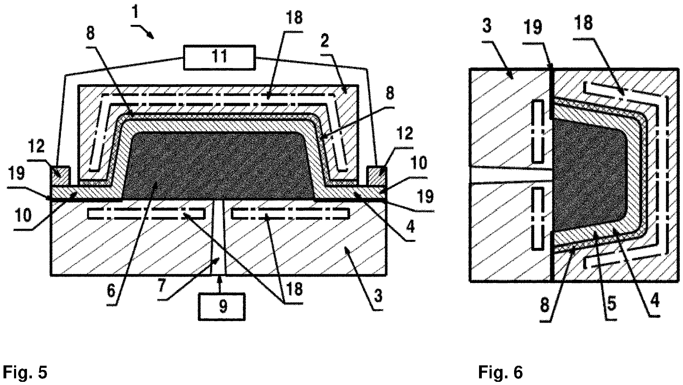

Fig. 5 zeigt dabei einen Schnitt A-A entlang einer Längsachse und Fig. 6 einen Schnitt B-B entlang einer Querachse des Spritzgusswerkzeugs 1 in Fig. 4, wobei das Spritzgusswerkzeug dabei z.B. lediglich ein Heizplattenelement aufweist, wie im Nachfolgenden erläutert wird.

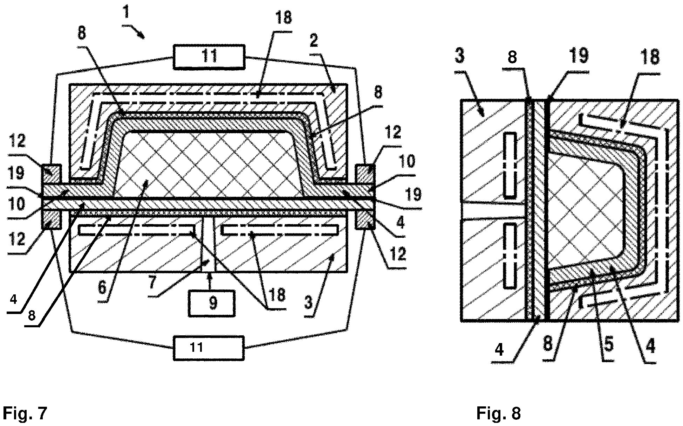

Die Fig. 7 und 8 zeigen wiederum ein zweites Ausführungsbeispiel des Spritzgusswerkzeugs gemäß Fig. 4. Fig. 7 zeigt hierbei einen Schnitt A-A entlang einer Längsachse und Fig. 8 einen Schnitt B-B entlang einer Querachse des Spritzgusswerkzeugs 1 in Fig. 4, wobei das Spritzgusswerkzeug gemäß dem zweiten Ausführungsbeispiel dabei zwei Heizplattenelemente 4 aufweist, wie ebenfalls im Folgenden erläutert wird.

Das Spritzgusswerkzeug 1 weist dabei eine erste und eine zweite Formhälfte 2, 3 auf, wobei die Formhälften 2, 3 in Fig. 4, 5, 6, 7 und 8 rein schematisch und stark vereinfach dargestellt sind.
Auf der Innenseite der ersten Formhälfte 2 ist dabei, statt einer metallischen Beschichtung wie bei anderen Spritzgusswerkzeugen, ein elektrisch beheizbares Heizplattenelement 4 austauschbar angebracht, wie in Fig. 5 und 6 gezeigt ist.

Als elektrisch beheizbares Heizplattenelement 4 kann dabei z.B. eine Metallplatte oder ein Blechteil 5 vorgesehen werden. Das Spritzgusswerkzeug 1 ist jedoch nicht auf ein Blechteil 5 oder eine Metallplatte als Heizplattenelement 4 beschränkt. Es kann jedes andere austauschbare Heizplattenelement vorgesehen werden, das elektrisch beheizbar insbesondere flächig oder vollflächig elektrisch beheizbar ist, durch Anlegen eines Stroms und einer Spannung an das Heizplattenelement und des Weiteren zum Einsatz in einem Spritzgusswerkzeug geeignet ist. Der an das Heizplattenelement angelegte elektrische Strom wird dabei von dem Heizplattenelement in Wärme umgewandelt und so dass Heizplattenelement durch Widerstandheizen erwärmt.

In dem in Fig. 7 und 8 gezeigten Ausführungsbeispiel kann auch die zweite Formhälfte 3 zusätzlich oder alternativ zu der ersten Formhälfte 2 mit einem elektrisch beheizbaren Heizplattenelement 4 versehen sein, beispielsweise einem Blechteil.

In dem Fall, dass beide Formhälften 2, 3 jeweils mit einem elektrisch beheizbaren Heizplattenelement 4 versehen sind, wie in dem in Fig. 7 und 8 gezeigten zweiten Ausführungsbeispiel, sind die beiden Heizplattenelemente 4 geeignet voneinander elektrisch isoliert, so dass kein Kurzschluss entsteht, wenn an die Heizplattenelemente 4 jeweils eine Spannung oder Strom angelegt wird zum Aufheizen des jeweiligen Heizplattenelements 4, wie im nachfolgenden noch beschrieben wird. Dabei kann, wie in dem Ausführungsbeispiel in Fig. 7 und 8 gezeigt ist, zur zusätzlichen elektrischen Isolierung der beiden Heizplattenelemente 4 beispielsweise eine elektrische Isolierung 19, insbesondere eine Lage aus einem elektrisch isolierenden Material, zwischen den beiden Heizplattenelementen 4 der ersten und zweiten Formhälfte 2, 3 vorgesehen sein.

Des Weiteren bildet das jeweilige Heizplattenelement 4 zusammen mit der gegenüberliegenden Formhälfte 3, wie in Fig. 5 und 6, oder dem anderen gegenüberliegenden Heizplattenelement, wie in Fig. 7 und 8, eine Kavität oder einen Formhohlraum 6.

In den Formhohlraum 6 wird dabei Spritzgussmaterial eingefüllt oder eingespritzt und geschäumt zur Herstellung des geschäumten Kunststoffbasisbauteils als Basis- oder Rohteil. Die Kavität oder der Formhohlraum 6 entspricht dabei der Form des herzustellenden geschäumten Kunststoffbasisbauteils.

Für das zu schäumende Spritzgussmaterial kann ein Kunststoff wie er anhand von Beispielen zuvor mit Bezug auf die Fig. 1 bis 3 und insbesondere mit Bezug auf Fig. 1 beschriebenen wurde eingesetzt und über wenigstens eine Zuführung 7 in den Formhohlraum 6 des Spritzgusswerkzeugs 1 eingespritzt werden, wie in Fig. 5, 6 bzw. in Fig. 7 und 8 beispielhaft und stark vereinfacht dargestellt ist. Wie ebenfalls zuvor mit Bezug auf die Fig. 1 bis 3 beschrieben wurde, können die Kunststoffe dabei z.B. optional durch Additive und/oder Füllstoffe für die Spritzgießverarbeitung und die spätere Verwendung modifiziert werden. Wie zuvor ausgeführt ist, ist die Erfindung jedoch auf die genannten Kunststoffe und Füllstoffe nicht beschränkt. Es kann jede Art von Kunststoff und Füllstoff eingesetzt werden, welcher zur Herstellung eines geschäumten Kunststoffbasisbauteils mit dem beschriebenen Spritzgusswerkzeug oder einem anderen Spritzgusswerkzeug geeignet ist.

Das Schäumen des Spritzgussmaterials erfolgt, wie zuvor mit Bezug auf die Fig. 1-3 beschrieben wurde, mittels eines chemischen Treibmittels und/oder eines physikalischen Treibmittels, so dass hierauf Bezug genommen wird, um unnötige Wiederholungen zu vermeiden.

Das jeweilige elektrisch beheizbare Heizplattenelement 4 ist an der zugeordneten Formhälfte, d.h. der Formhälfte 2 in Fig. 5 und 6 sowie der Formhälfte 2 und der Formhälfte 3 in Fig. 7 und 8, wahlweise zusätzlich austauschbar befestigt, beispielsweise mittels eines Klebemittels 8 als Befestigungsmittel. Das Klebemittel 8 ist dabei z.B. ein Klebstoff, insbesondere ein flüssiger oder pastöser Klebstoff, oder ein Klebefilm. Um mechanisch und thermisch belastet zu werden kann der Klebstoff z.B. zunächst aushärten bevor mit einem ersten Spitzgusszyklus begonnen wird.

Das Klebemittel 8 ist derart gewählt, dass es das Heizplattenelement 4 an der jeweiligen Formhälfte 2 bzw. 3 befestigt und wenigstens einen Spritzgusszyklus standhält, ohne dass das Heizplattenelement 4 sich von der Formhälfte 2 bzw. 3 ungewollt teilweise oder vollständig löst. In den in Fig. 5 und 6 bzw. Fig. 7 und 8 gezeigten Ausführungsbeispielen weist das Klebemittel 8 eine Klebemittelschicht-Dicke von z.B. kleiner als 0,3mm auf. Das Spritzgusswerkzeug ist jedoch nicht auf diese Schichtdicke beschränkt. Je nach Funktion und Einsatzzweck kann das Klebemittel 8 auch eine Klebemittelschicht-Dicke von gleich oder größer 0,3mm aufweisen.
Des Weiteren ist das Klebemittel 8 vorzugsweise zusätzlich elektrisch isolierend, um das Heizplattenelement 4 und die zugeordnete Formhälfte 2 bzw. 3 voneinander elektrisch zu isolieren. Es kann jedoch auch jede andere Form der elektrischen Isolierung zusätzlich oder alternativ zu dem elektrisch isolierenden Klebemittel 8 vorgesehen werden, welche geeignet ist, die Formhälfte 2 bzw. 3 und das mit ihr verbundene Heizplattenelement 4 elektrisch zu isolieren, um einen Kurzschluss zwischen der Formhälfte 2 bzw. 3 und dem Heizplattenelement 4 zu verhindern. In einem Ausführungsbeispiel kann das Klebemittel 8 auch thermisch isolierend oder im Wesentlichen thermisch isolierend vorgesehen sein.

Statt eines Klebemittels 8 kann auch jede andere Art von Befestigungsmittel oder Kombination von Befestigungsmitteln vorgesehen werden, welches bzw. welche geeignet sind, das Heizplattenelement 4 austauschbar mit der Formhälfte 2 in dem Ausführungsbeispiel in Fig. 5 und 6 sowie der Formhälfte 2 bzw. Formhälfte 3 in dem Ausführungsbeispiel in Fig. 7 und 8 zu verbinden, so dass das Heizplattenelement 4 gegebenenfalls zusammen mit dem wenigstens einen Befestigungsmittel bei Bedarf ausgetauscht werden kann. Dabei ist ebenfalls eine elektrische Isolierung zwischen dem Heizplattenelement 4 und der Formhälfte 2 in dem Ausführungsbeispiel in Fig. 5 und 6 sowie zwischen dem Heizplattenelement und der Formhälfte 2 bzw. der Formhälfte 3 in dem Ausführungsbeispiel in Fig. 7 und 8 vorgesehen. Diese elektrische Isolierung kann durch das Befestigungsmittel oder die Kombination von Befestigungsmitteln selbst bereitgestellt werden und/oder durch eine elektrische Isolierung, welche unabhängig von dem Befestigungsmittel oder Kombination von Befestigungsmitteln ist.

Dabei wird in einem Ausführungsbeispiel lediglich das Heizplattenelement 4 mit dem Klebemittel 8 nach wenigstens einem oder vorzugsweise mehreren Spritzgusszyklen entfernt und ersetzt. Dies hat den Vorteil, dass nicht die gesamte Formhälfte ersetzt werden muss. Das Klebemittel 8 lässt sich zudem leicht von der Formhälfte lösen, insbesondere wenn die Formhälfte aus Metall ist.

Wie zuvor beschrieben wird als Heizplattenelement 4 beispielsweise ein Blechteil 5 eingesetzt. Das Blechteil 5 ist elektrisch beheizbar durch Anlegen eines Stroms einer Spannung an das Blechteil. Des Weiteren ist das Blechteil 5 als Heizplattenelement 4 für das Spritzgussverfahren geeignet temperaturbeständig. Die Form des Blechteils 5 kann zur Bereitstellung des gewünschten Formhohlraums 6 und des darin herzustellenden Bauteils beispielsweise durch Tiefziehen hergestellt werden oder durch jedes andere geeignete Verfahren oder jede andere geeignete Kombination von Verfahren.

Als Blechteil 5 wird beispielsweise ein Blechteil aus Aluminium, insbesondere einer Aluminiumlegierung, oder einem Stahl oder einer Stahllegierung verwendet. Die Erfindung ist jedoch auf die genannten Materialien nicht beschränkt.

In dem in den Fig. 5 und 6 gezeigten Ausführungsbeispiel wird das Blechteil 5 an der Innenseite der ersten Formhälfte 2 des Spritzgusswerkzeugs 1 befestigt und in dem in den Fig. 7 und 8 gezeigten Ausführungsbeispiel ein Blechteil 5 an der Innenseite der ersten Formhälfte 2 und ein Blechteil 5 an der Innenseite der zweiten Formhälfte 3. Als Heizplattenelement 4 bildet das jeweilige Blechteil 5 dabei mit seiner dem Formhohlraum 6 zugewandten Seite beispielsweise die Sichtseite des herzustellenden geschäumten Kunststoffbasisbauteils, welche anschließend beschichtet wird, wie zuvor mit Bezug auf die Fig. 1-3 beschrieben wurde, zur Herstellung des fertigen
beschichteten Kunststoffbauteils.

Mittels des jeweiligen Blechteils 5, kann das geschäumte Kunststoffbasisbauteil, insbesondere auch große geschäumte Kunststoffbauteile, mit einer verbesserten Oberflächenqualität hergestellt werden, wie im Folgenden noch erläutert wird, die anschließend beschichtet wird, wie mit Bezug auf die Fig. 1-3 beschrieben wurde.

Falls z.B. die Sichtseite des herzustellenden geschäumten Kunststoffbasisbauteils zwischen der ersten und zweiten Formhälfte 2, 3 verläuft, kann auch die zweite Formhälfte 3 mit einem Heizplattenelement, hier z.B. Blechteil, versehen werden, wie in dem Ausführungsbeispiel in Fig. 7 und 8 illustriert ist.

Die wenigstens eine Zuführung 7 zum Einspritzen des Spritzgussmaterials in den Formhohlraum 6 kann dabei beispielsweise in der Formhälfte 3 vorgesehen werden, welche kein Heizplattenelement 4 aufweist, wie in dem Ausführungsbeispiel in Fig. 5 und 6 stark vereinfacht und rein schematisch dargestellt ist. Die Zuführung 7 ist dabei mit einer Zuführungseinrichtung 9 zum Einspritzen des Spritzgussmaterials in den Formhohlraum 6 verbunden.

Grundsätzlich ist es aber denkbar die Zuführung 9 in einer Formhälfte 3 auch durch deren vorhandenes Heizplattenelement 4 hindurch in den Formhohlraum 6 vorzusehen, beispielsweise wenn beide Formhälften 2 und 3 durchgehend jeweils mit einem Heizplattenelement versehen sind, wie in dem Ausführungsbeispiel in Fig. 7 und 8 gezeigt ist. Die Zuführung 9 ist dabei gegenüber dem Heizplattenelement 4 derart elektrisch isoliert ausgebildet, dass ein Kurzschluss zwischen der Zuführung 9, der Formhälfte 3 und dem Heizplattenelement 4 verhindert wird.

Das an der jeweiligen Formhälfte 2 bzw. 3 befestige Heizplattenelement 4, z.B. Blechteil 5, ragt zumindest mit einem Abschnitt 10 auf einer oder wie in den Ausführungsbeispielen in Fig. 5 und 6 bzw. 7 und 8 gezeigt ist, auf beiden Seiten aus der Formhälfte 3 bzw. 2 heraus, um an eine jeweilige Energiequelle 11 angeschlossen zu werden zum elektrischen Beheizen des Heizplattenelements 4. Die Energiequelle 11 weist dabei wenigstens eine Stromquelle und/oder eine Spannungsquelle auf.

In den in den Fig. 5 und 6 bzw. Fig. 7 und 8 gezeigten Ausführungsbeispielen erstreckt sich das Heizplattenelement 4 z.B. über die gesamte Innenseite der Formhälfte 2 bzw. 3 oder zumindest über den gesamten durch diese Formhälfte 2 bzw. 3 gebildeten Teil des Formhohlraums 6 bzw. der Kavität. Falls die Sichtseite des herzustellenden Spritzguss-Bauteils sich z.B. nicht über diese gesamte zugeordnete Formhälfte 2 bzw. 3 erstreckt, kann das jeweilige Heizplattenelement 4 z.B. derart vorgesehen sein, dass es sich nur über den Bereich dieser Formhälfte 2 bzw. 3 erstreckt, die mit dem Heizplattenelement 4 die Sichtseite des geschäumten Kunststoffbasisbauteils bildet. Das Heizplattenelement 4 ragt jedoch, auch hier, mit wenigstens einem Abschnitt 10 aus der Formhälfte 2 bzw. 3 heraus, um an die zugeordnete Stromquelle 11 angeschlossen zu werden.

Der aus der Formhälfte 2 bzw. 3 herausragende Abschnitt 10 des jeweiligen Heizplattenelements 4 wird mit einem oder mehreren Kontakten 12 zur Energiezufuhr versehen. Die Kontakte 12 sind dabei an die zugeordnete Energiequelle 11 angeschlossen. Des Weiteren sind die mit der Energiequelle 11 verbundenen Kontakte 12 derart an dem Abschnitt 10 oder Abschnitten 10 des jeweiligen Heizplattenelements 4 angeordnet, dass das Heizplattenelement 4 z.B. möglichst flächig beheizbar ist.

Dabei kann z.B. eine Stromstärke von größer 100A und/oder eine Spannung von größer 40V an das Heizplattenelement 4, hier z.B. das Blechteil 5 in Fig. 5 und 6 bzw. Fig. 7 und 8, über die Kontakte 12 und die Energiequelle 11 angelegt werden. Das Blechteil 5 weist hierbei eine Dicke z.B. in einem Bereich von 0,1 mm bis 4mm auf. Aufgrund der geringen Dicke des Blechteils 5 und der im Verhältnis dazu hohen Stromstärke erwärmt sich das Blechteil 5 innerhalb weniger Sekunden beispielsweise auf eine Temperatur von mehr als 100°C bis zu wenigstens 150°C oder wenigstens 200°C.

In einem Ausführungsbeispiel wird das Blechteil 5 auf eine Temperatur in einem Bereich zwischen 130°C und 170°C erwärmt. Ist dieser Temperaturbereich erreicht, so kann mit einem Einspritzvorgang gestartet werden zum Herstellen des geschäumten Kunststoffbasisbauteils.

Abhängig von der Fließweglänge des eingespritzten Kunststoffs zu dem herzustellenden Bauteil wird die Stromzufuhr durch die Energiequelle 11, z.B. in Form wenigstens einer Stromquelle, mit Ende des Einspritzvorgangs oder auch noch vor dem Ende des Einspritzvorgangs gestoppt. Je nach eingespritztem Material ist die Fließweglänge unterschiedlich.

Das Blechteil 5 als Beispiel für ein Heizplattenelement 4 beginnt sich dabei abzukühlen. Dieser Abkühlvorgang kann in einem Ausführungsbeispiel durch das Spritzgusswerkzeug 1 wahlweise zusätzlich unterstützt werden. Dabei kann wenigstens eine Formhälfte 2, 3 des Spritzgusswerkzeugs 1 mit einer zusätzlichen Temperiereinrichtung 18 ausgebildet sein zum Kühlen und/oder Heizen der Formhälfte 2, 3, wie in den Ausführungsbeispielen in Fig. 5 und 6 bzw. Fig. 7 und 8 gezeigt ist. Die Temperiereinrichtungen 18 der ersten und zweiten Formhälfte 2, 3 sind dabei stark vereinfacht und nicht maßstäblich in Fig. 5 und 6 sowie in Fig. 7 und 8 jeweils mit einer strichpunktierten Linie angedeutet. Die Temperiereinrichtung 18 kann sich wenigstens entlang eines Abschnitts der zugeordneten Formhälfte 2, 3 erstrecken.

Um den Abkühlvorgang zu unterstützen kann die Formhälfte 2, 3 des Spritzgusswerkzeugs 1 mittels ihrer Temperiereinrichtung 18 zusätzlich z.B. gekühlt werden.

Die thermische Isolierung durch das Klebemittel 8 zum Befestigen des jeweiligen Heizplattenelements 4 an der Formhälfte 2 in dem Ausführungsbeispiel in Fig. 5 und 6 bzw. an der Formhälfte 2 und der Formhälfte 3 in dem Ausführungsbeispiel in Fig. 7 und 8, ist dabei vorzugsweise ausreichend gering, so dass keine, im Wesentlichen keine oder nur eine geringfügige Zyklusverlängerung verursacht wird, verglichen mit einem konventionellen Spritzgussvorgang.

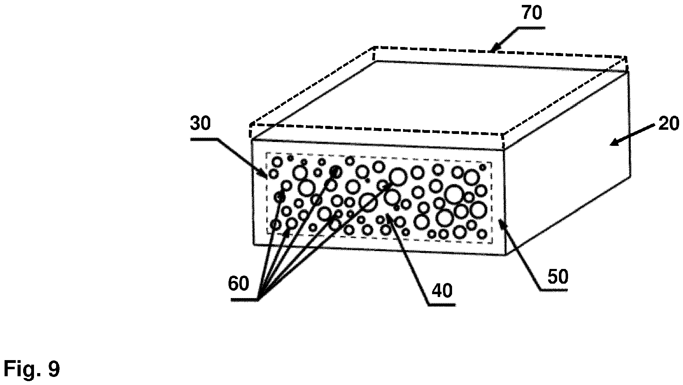

In Fig. 9 ist eine Schnittansicht des, mittels des Spritzgusswerkzeugs der Fig. 4-6, fertig hergestellten geschäumten Kunststoffbasisbauteils 20 gezeigt. Das geschäumte Kunststoffbasisbauteil 20 wird anschließend zur Herstellung des fertigen beschichteten Kunststoffbauteils, wie zuvor in den Fig. 1-3, zumindest in einem Abschnitt, z.B. einem Abschnitt der Sichtseite des Kunststoffbasisbauteils 20, mit einer zusätzlichen Beschichtung aus wenigstens einer oder mehreren Schichten versehen. Beispiele solcher Schichten wurden zuvor mit Bezug auf die Fig. 1-3 beschrieben. In dem in Fig. 9 gezeigten Beispiel kann das geschäumte Kunststoffbasisbauteil 20 beispielsweise mit wenigstens einer PVD-Schicht 70, wie mit einer gestrichelten Linie angedeutet ist, in einem Abschnitt versehen sein zur Ausbildung des fertig beschichteten Kunststoffbauteils.

Ein mittels des Spritzgusswerkzeugs gemäß der Fig. 4 und 7-8 hergestelltes geschäumtes Kunststoffbasisbauteil entspricht ebenfalls prinzipiell dem in Fig. 9 gezeigten geschäumten Kunststoffbasisbauteil 20, so dass die Ausführungen zu Fig. 9 entsprechend auch für das Ausführungsbeispiel gemäß der Fig. 7 und 8 gelten und daher nicht wiederholt werden. Anschließend erfolgt dabei ebenfalls eine Beschichtung des geschäumten Kunststoffbasisbauteils mit wenigstens einer Schicht, z.B. eine PVD-Schicht usw. Bei dem Einsatz eines Spritzgusswerkzeugs mit dem Aufbau gemäß dem in Fig. 7 und 8 gezeigten Ausführungsbeispiel kann dabei nicht nur die Oberseite sondern auch die Unterseite des Spritzgussbauteils als Sichtfläche dienen und beispielsweise anschließend beschichtet werden, da beide Formhälften mit einem Heizplattenelement versehen sind.

Wie zuvor beschrieben, wird das Spritzgussmaterial in dem Formhohlraum oder der Kavität des Spritzgusswerkzeugs, wie es in den Fig. 4-8 gezeigt ist, geschäumt. Das Schäumen des Spritzgussmaterials erfolgt dabei mittels eines chemischen Treibmittels und/oder eines physikalischen Treibmittels. Das chemische Treibverfahren und das physikalische Treibverfahren und die dort jeweils eingesetzten Treibmittel wurden bereits ausführlich mit Bezug auf die Fig. 1-3 beschrieben.

Durch das Schäumen des Spritzgussmaterials kann die Schaumstruktur bzw. Integralschaumstruktur 30 erhalten werden mit dem geschäumten Kern 40 und der kompakten Randschicht 50. Der geschäumte Kern 40 ist dabei mit einer gestrichelten Linie in Fig. 6 und gepunkteten Blasen 60 stark vereinfacht und rein schematisch dargestellt. Das Schäumen des Spritzgussmaterials kann dabei durch wenigstens einen Prozessparameter, wie z.B. den Einspritzdruck, die Einspritztemperatur, die Temperatur oder den Temperaturverlauf des in den Formholraum eingespritzten Spritzgussmaterials, die Teilewandstärke des herzustellenden Bauteils und/oder den Aufschäumgrad usw. beeinflusst werden. Zur Bestimmung der Einspritztemperatur sowie der Temperatur im Formhohlraum und dem Temperaturverlauf im Formhohlraum können ein oder mehrere Temperatursensoren vorgesehen werden.

Bei dem Spritzgussteil wird beispielsweise eine möglichst homogene Verteilung über dem Teilequerschnitt angestrebt. Im Allgemeinen gilt folgendes: Mit dem physikalischen Schäumen wird in der Regel eine gleichmäßigere Schaumstruktur erzielt. Wobei die Blasen hier häufiger und kleiner sind. Beim chemischen Schäumen ist die Struktur etwas ungleichmäßiger mit weniger und größeren Blasen.

Die Darstellung des geschäumten Kunststoffbasisbauteils 20 als plattenförmiges Element in Fig. 9 ist lediglich beispielhaft, stark vereinfacht und dient nur zur Veranschaulichung des Prinzips der Erfindung. Grundsätzlich kann das geschäumte Kunststoffbasisbauteil 20 und anschließend das daraus hergestellte fertige beschichtete Kunststoffbauteil eine beliebig komplexe Form aufweisen mit z.B. Vertiefungen, Erhebungen, Wölbungen usw..

Wie zuvor in den Fig. 1-3 mit Bezug auf das 1-schalige Konzept beschrieben wurde, kann das geschäumte Kunststoffbasisbauteil 20 und anschließend das daraus hergestellte fertige beschichtete Kunststoffbauteil an der Unterseite als Funktionsteil beispielsweise ein oder mehrere Befestigungselemente, z.B. wenigstens ein Verclipsungs- und/oder Verrastungselement, zum Befestigen z.B. an einem Fahrzeug aufweisen und die Oberseite das sichtbare Teil oder sog. Design-Teil bilden und eine hochwertige Oberfläche mit einer entsprechenden Passgenauigkeit bezüglich Spaltmaßen und Gesamtverzug bereitstellt.

Als geschäumtes Kunststoffbasisbauteil 20 und anschließend das daraus hergestellte fertige beschichtete Kunststoffbauteil können alle Arten von Bauteilen hergestellt werden, insbesondere solche, bei denen hohe Anforderungen, z.B. eine sogenannte "A-Surface-Qualität", an die Sichtfläche gestellt werden. In Verbindung mit der immer stärker werdenden Forderung nach Teilegewichtsreduzierung eröffnet die Erfindung neue Möglichkeiten hinsichtlich der notwendigen CO²-Reduzierung beispielsweise in der Automobilindustrie. So können z.B. Zierleisten, Säulenverkleidungen, Türverkleidungen, Radläufe, Schweller, Spoiler, die Instrumententafel oder Teile davon sowie weitere beschichtete Kunststoffbauteile für den Innenbereich und dem Außenbereich bei einem Fahrzeug hergestellt werden usw.. Auch ist das Herstellen von beschichteten Kunststoffbauteilen z.B. im Bereich der Medizintechnik möglich, insbesondere von sog. "weißer Ware".

Mittels des Vorsehens wenigstens eines elektrisch beheizbaren Heizplattenelements an einer Formhälfte des Spritzgusswerkzeugs der Fig. 4 bis 8 und dem Schäumen des Spritzgussmaterials in dem Spritzgusswerkzeug können beliebige geschäumte Kunststoffbasisbauteile hergestellt und anschließend beschichtet werden. Insbesondere können auf diese Weise geschäumte Kunststoffbasisbauteile, sowohl bei Einsatz eines chemischen als auch eines physikalischen Treibmittels, mit einer hochwertigen Oberfläche hergestellt werden, ohne oder im Wesentlichen ohne sogenannte Silberschlieren. Dadurch wird es möglich, dass diese als Roh- oder Ausgangsteile genutzt und beschichtet werden können.

Des Weiteren können neben kleinen auch großflächige geschäumte und beschichtete Kunststoffbauteile, insbesondere für den Fahrzeuginnenbereich und Fahrzeugaußenbereich, mit einem deutlich geringeren Gewicht hergestellt werden, ohne bei der Oberflächenqualität Abstriche machen zu müssen. Beispielsweise kann je nach Produktdesign bei dem geschäumten und beschichteten Kunststoffbauteil eine Gewichtsersparnis in einem Bereich von z.B. 10% bis 40% erzielt werden.

Das elektrische Aufheizen des Heizplattenelements erlaubt ein gezieltes Steuern und/oder Regeln des Aufheizens oder anschließenden Abkühlens des Heizplattenelements durch ein gezieltes Steuern und/oder Regeln des durch die Energiequelle 11 angelegten Stroms und/oder angelegten Spannung. Dadurch kann das Aufheizen des Heizplattenelements individuell an das herzustellende geschäumte Kunststoffbasisbauteil angepasst werden. Wie zuvor beschrieben weist die Energiequelle 11 wenigstens eine Stromquelle und/oder Spannungsquelle auf. Zum Steuern und/oder Regeln der Temperatur des Spritzgussmaterials im Formhohlraum mittels der Temperiereinrichtung werden z.B. ein oder mehrere Temperatursensoren eingesetzt mit welchen die Temperatur des Spritzgussmaterials im Formhohlraum direkt oder indirekt bestimmbar ist. So kann das Heizplattenelement kontinuierlich oder diskontinuierlich geheizt und/oder abgekühlt werden durch Anpassen der an das Heizplattenelement angelegten Spannung oder angelegten Stroms und dadurch individuell auf das herzustellende geschäumte Kunststoffbasisbauteil abgestimmt werden.
Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar. Die zuvor beschriebenen Ausführungsformen wie sie beispielhaft mit Bezug auf die Fig. 1 bis 3 beschrieben wurden sind miteinander kombinierbar insbesondere einzelne Merkmale davon.

### Bezugszeichenliste

- 1: Spritzgusswerkzeug
- 2: Erste Formhälfte
- 3: Zweite Formhälfte
- 4: Heizplattenelement
- 5: Blechteil
- 6: Formhohlraum
- 7: Zuführung
- 8: Klebemittel
- 9: Zuführungseinrichtung
- 10: Abschnitt
- 11: Energiequelle
- 12: Kontakt
- 13: Spritzguss-Bauteil
- 18: Temperiereinrichtung
- 19: Elektrische Isolierung

- 100: Beschichtetes Kunststoffbauteil
- 20: Kunststoffbasisbauteil (Basis- oder Rohteil)
- 30: Schaumstruktur
- 40: Geschäumter Kern
- 50: Randschicht
- 60: Blase
- 70: PVD-Schicht
- 80: Außenseite
- 90: Zwischenschicht
- 110: Zusätzliche Schicht
- 120: Lackschicht

## Patentansprüche

1. Beschichtetes Kunststoffbauteil (100), insbesondere für einen Innen- und/oder Außenbereich eines Fahrzeugs, aufweisend:
ein geschäumtes Kunststoffbasisbauteil (20), welches auf seiner Außenseite in wenigstens einem Bereich mit wenigstens einer Schicht, insbesondere einer Lack- oder PVD-Schicht (70), versehen ist.

2. Beschichtetes Kunststoffbauteil nach Anspruch 1,
**dadurch gekennzeichnet,**
**dass** das Kunststoffbasisbauteil (20) durch chemisches Schäumen und/oder physikalisches Schäumen hergestellt ist.

3. Beschichtetes Kunststoffbauteil nach Anspruch 1 oder 2,
**dadurch gekennzeichnet,**
**dass** zwischen der wenigstens einen PVD-Schicht (70) und der Außenseite des Kunststoffbasisbauteils (20) wenigstens eine zusätzliche Schicht (90, 110, 100) vorgesehen ist, wobei die wenigstens eine zusätzliche Schicht insbesondere eine Lackschicht, Haftgrundschicht und/oder Pufferschicht ist.

4. Beschichtetes Kunststoffbauteil nach einem der vorstehenden Ansprüche,
**dadurch gekennzeichnet,**
**dass** mehrere PVD-Schichten (70) vorgesehen sind.

5. Beschichtetes Kunststoffbauteil nach einem der vorstehenden Ansprüche,
**dadurch gekennzeichnet,**
**dass** zwischen wenigstens zwei PVD-Schichten (70) wenigstens eine zusätzliche Schicht vorgesehen ist, wobei die wenigstens eine zusätzliche Schicht insbesondere eine Lackschicht, Haftgrundschicht und/oder Pufferschicht ist.

6. Beschichtetes Kunststoffbauteil nach einem der vorstehenden Ansprüche,
**dadurch gekennzeichnet,**
**dass** auf der äußersten PVD-Schicht (70) wenigstens eine zusätzliche Schicht (111,110) vorgesehen ist, wobei die wenigstens eine zusätzliche Schicht insbesondere eine Lackschicht (110), Deckschicht oder Schutzschicht ist.

7. Beschichtetes Kunststoffbauteil nach einem der vorstehenden Ansprüche,
**dadurch gekennzeichnet,**
**dass** die wenigstens eine PVD-Schicht (70) aus einem Metall, einer Metalllegierung, einem Carbid, einem Oxid und/oder einem Nitrid besteht oder dieses zumindest aufweist.

8. Beschichtetes Kunststoffbauteil nach einem der vorstehenden Ansprüche,
**dadurch gekennzeichnet,**
**dass** das beschichtete Kunststoffbauteil (100) ein Radlauf, ein Schweller, eine Zierleisten, eine Säulenverkleidungen, eine Türverkleidungen, ein Spoiler, oder zumindest ein Teil einer Instrumententafel ist.

9. Verfahren zur Herstellung eines beschichteten Kunststoffbauteils (100), insbesondere eines beschichteten Kunststoffbauteils gemäß den Ansprüchen 1 bis 8, wobei das Verfahren die Schritte aufweist:
Erzeugen eines Kunststoffbasisbauteils (20) durch chemischen Schäumen und/oder physikalisches Schäumen wenigstens eines Kunststoffes; und
Versehen zumindest eines Bereichs der Außenseite des Kunststoffbasisbauteils (20) mit wenigstens einer Schicht, insbesondere einer Lack- oder PVD-Schicht (70).

10. Verfahren nach Anspruch 9,
**gekennzeichnet durch,**
wobei der Schritt des Erzeugens eines Kunststoffbasisbauteils (20) aufweist:
Bereitstellens eines Spritzgusswerkzeugs mit einer ersten Formhälfte (2) und einer zweiten Formhälfte (3),
wobei eine oder beide Formhälften (2, 3) jeweils auf ihrer Innenseite zumindest in einem Bereich mit einem elektrisch beheizbaren Heizplattenelement (4, 5) versehen ist bzw.
sind, wobei das Heizplattenelement (4, 5) der zugeordneten Formhälfte (2, 3) einen Teil eines Formhohlraums (6) des Spritzgusswerkzeugs (1) bildet,
Versehen des wenigstens einen Kunststoffes mit einem chemischen Treibmittel und/oder einem physikalischen Treibmittel und
Einspritzen des wenigstens einen Kunststoffs in den Formhohlraum (6) zur Erzeugen des Kunststoffbasisbauteils (20).

11. Verfahren nach Anspruch 10,
**gekennzeichnet durch,**
wobei der Schritt des Erzeugens eines Kunststoffbasisbauteils (20) aufweist:
Aufheizen des Heizplattenelements (4, 5) der einen Formhälfte (2, 3) oder wenigstens eines der beiden Heizplattenelemente (4, 5) der beiden Formhälften (2, 3) auf eine vorbestimmte Temperatur vor dem Einspritzen, während dem Einspritzen und/oder nach dem Einspritzen des wenigstens einen Kunststoffs in den Formhohlraum (6).

12. Verfahren nach Anspruch 11,
**gekennzeichnet durch,**
Aufheizen des Heizplattenelements (4, 5) der einen Formhälfte (2, 3) oder wenigstens eines der beiden Heizplattenelemente (4, 5) der beiden Formhälften (2, 3) auf eine Temperatur, insbesondere eine Einspritz-Temperatur in einem Bereich von 120°C bis 200°C, vorzugsweise nur während dem Einspritzen des Kunststoffmaterials; und/oder Stoppen des Aufheizens des Heizplattenelements (4, 5) der einen Formhälfte (2, 3) oder wenigstens eines der beiden Heizplattenelemente (4, 5) der beiden Formhälften (2, 3) und gegebenenfalls zusätzliches Kühlen des Heizplattenelements (4, 5) der einen Formhälfte (2, 3) oder wenigstens eines der beiden Heizplattenelemente (4, 5) der beiden Formhälften (2, 3) nach dem Ende des Einspritzens des Spritzgussmaterials.

13. Verfahren nach einem der Ansprüche 9 bis 12,
**gekennzeichnet durch,**
Temperieren wenigstens einer der Formhälften (2, 3) durch Kühlen und/oder Heizen der Formhälfte (2, 3) vor dem Einspritzen, während dem Einspritzen und/oder nach dem Einspritzen des wenigstens einen Kunststoffs in den Formhohlraum (6); und/oder kontinuierliches oder diskontinuierliches Aufheizen und/oder Kühlen des Heizplattenelements (4, 5) der einen Formhälfte (2, 3) oder wenigstens einer der beiden Heizplattenelemente (4, 5) der beiden Formhälften (2, 3), vor dem Einspritzen, während dem Einspritzen und/oder nach dem Einspritzen des wenigstens einen Kunststoffs in den Formhohlraum (6); und/oder
Aufbringen wenigstens einer zusätzlichen Schicht (90, 110, 111) zwischen dem zumindest einen Bereich der Außenseite des Kunststoffbasisbauteils (20) und der PVD-Schicht (70).

14. Verfahren nach einem der Ansprüche 9 bis 13,
**gekennzeichnet durch,**
wobei der Schritt des Versehens zumindest eines Bereichs der Außenseite des Kunststoffbasisbauteils (20) mit wenigstens einer PVD-Schicht (70) aufweist:
physikalisches Gasphasenabscheiden wenigstens eines Metalls, einer Metalllegierung, einem Carbid, einem Oxid und/oder einem Nitrid als PVD-Schicht (70); und/oder
Aufbringen wenigstens einer zusätzlichen Schicht zwischen wenigstens zwei PVD-Schichten (70); und/oder
Aufbringen wenigstens einer zusätzlichen Schicht (110) auf der äußersten PVD-Schicht (70).

15. Verfahren nach einem der Ansprüche 13 oder 14,
**dadurch gekennzeichnet,**
**dass** die wenigstens eine zusätzliche Schicht (90, 110, 111) eine Lackschicht (110), eine Haftgrundschicht, eine Pufferschicht, eine Funktionsschicht, eine Schutzschicht und/oder eine Deckschicht ist, wobei die Funktionsschicht insbesondere wenigsten einen Sensor, vorzugsweise einen Temperatur- und/oder Abstandsensoren, und/oder eine Energieerzeugungseinrichtung zur Nutzung von Sonnenenergie und/oder Wärmeenergie und/oder wenigstens eine Einrichtung zur Informationsübertragung und/oder zum Informationsempfang aufweist.
